# EUROPEAN PATENT APPLICATION

(11) **EP 2 672 534 A2**
(43) Date of publication of application: **11.12.2013**
(21) Application number: 13158345.2
(22) Date of filing: 08.03.2013
(51) Int. Cl.: H01L 33/62

(54) **Semiconductor board, semiconductor device, and producing method of semiconductor device**

(30) Priority: 27.03.2012 JP 2012071126
(71) Applicant: Nitto Denko Corporation, Ibaraki-shi Osaka 567-8680 (JP)
(72) Inventor: Kimura, Ryuichi, Osaka 567-8680 (JP)
(74) Representative: HOFFMANN EITLE

(57) **Abstract**

A semiconductor board includes a circuit board to which external electric power is supplied; a plurality of semiconductor elements which are supported on the circuit board; and a plurality of wires each of which is provided corresponding to each of a plurality of the semiconductor elements and each of which has one end electrically connected to the semiconductor element and the other end electrically connected to the circuit board. A plurality of the wires extend along a radial direction of a phantom circle having a center on the circuit board.

## Description

### BACKGROUND OF THE INVENTION

### Field of the Invention

The present invention relates to a semiconductor board, a semiconductor device provided with the semiconductor board, and a method for producing a semiconductor device.

### Description of Related Art

Conventionally, it has been known that a semiconductor element such as a light emitting diode (LED) is encapsulated by a resin.

It has been proposed that an optical semiconductor encapsulating sheet having a resin layer prepared from a silicone resin is disposed on an LED chip-mounted board on which a plurality of LED chips are mounted and the optical semiconductor encapsulating sheet is heated and pressurized with respect to the LED chip-mounted board, so that a plurality of the LED chips are encapsulated by the resin layer (ref: for example, Japanese Unexamined Patent Publication No. 2010-123802).

### SUMMARY OF THE INVENTION

However, when the LED chip-mounted board (a so-called wire bonding type) in which the LED chips are connected to the board by wires is encapsulated by the above-described method described in Japanese Unexamined Patent Publication No. 2010-123802, there may be a case where, when the optical semiconductor encapsulating sheet is heated and pressurized with respect to the LED chip-mounted board, the softened resin layer moves and the wires are deformed (inclined) in a moving direction of the resin layer.

When the wires are deformed, a connection of the wires to the LED chips or a connection of the wires to the board may be broken.

It is an object of the present invention to provide a semiconductor board which is capable of suppressing a deformation of a wire at the time of encapsulating a semiconductor element, a semiconductor device which is provided with the semiconductor board, and a method for producing a semiconductor device.

A semiconductor board of the present invention includes a circuit board to which external electric power is supplied; a plurality of semiconductor elements which are supported on the circuit board; and a plurality of wires each of which is provided corresponding to each of a plurality of the semiconductor elements and each of which has one end electrically connected to the semiconductor element and the other end electrically connected to the circuit board, wherein a plurality of the wires extend along a radial direction of a phantom circle having a center on the circuit board.

In the semiconductor board of the present invention, it is preferable that a plurality of the semiconductor elements are light emitting diodes.

In the semiconductor board of the present invention, it is preferable that the wire diameter of each of a plurality of the wires is 10 to 100 µm.

In the semiconductor board of the present invention, it is preferable that a plurality of the semiconductor elements are disposed in a plurality of rows so as to be along the radial direction of the phantom circle.

A semiconductor device of the present invention includes the above-described semiconductor board and an encapsulating layer which collectively encapsulates a plurality of semiconductor elements.

In the semiconductor device of the present invention, it is preferable that the encapsulating layer is obtained by allowing an encapsulating sheet formed from an encapsulating resin into a sheet shape to be cured.

In the semiconductor device of the present invention, it is preferable that the encapsulating resin is a silicone resin.

A method for producing a semiconductor device of the present invention includes the steps of preparing the above-described semiconductor board, disposing an encapsulating sheet formed from an encapsulating resin into a sheet shape at the upper side of the semiconductor board, and pressurizing the encapsulating sheet with respect to the semiconductor board so as to be deformed toward the direction in which a plurality of wires extend.

A method for producing a semiconductor device of the present invention includes the steps of preparing a semiconductor board which includes a circuit board to which external electric power is supplied, a semiconductor element which is supported on the circuit board, and a wire which has one end electrically connected to the semiconductor element and the other end electrically connected to the circuit board; disposing an encapsulating sheet formed from an encapsulating resin into a sheet shape at the upper side of the semiconductor board; and pressurizing the encapsulating sheet with respect to the semiconductor board so as to be deformed toward the direction in which the wire extends.

According to the semiconductor board of the present invention, the wires which electrically connect the semiconductor elements to the circuit board extend so as to be along the radial direction of the phantom circle having a center on the circuit board.

Therefore, when the semiconductor device is produced, the encapsulating sheet is compressed so as to extend from the center on the circuit board along the radial direction of the phantom circle, so that the direction in which the encapsulating sheet extends and the direction in which the wires extend can be substantially matched with each other.

In this way, the pressing force with respect to the wires at the time of compression of the encapsulating sheet can be reduced.

As a result, the deformation of the wires at the time of encapsulating the semiconductor elements can be suppressed.

According to the method for producing a semiconductor device of the present invention, the encapsulating sheet is pressurized with respect to the semiconductor board so as to be deformed toward the direction in which the wires extend.

Therefore, the direction in which the encapsulating sheet extends and the direction in which the wires extend can be substantially matched with each other.

As a result, the pressing force with respect to the wires at the time of compression of the encapsulating sheet can be reduced.

### BRIEF DESCRIPTION OF THE DRAWINGS

FIG. 1 shows one embodiment of a semiconductor device of the present invention:
   (a) illustrating a plan view of the semiconductor device and
   (b) illustrating an A-A sectional view of the semiconductor device.
FIG. 2 shows a semiconductor board shown in FIG. 1:
   (a) illustrating a plan view of the semiconductor board and
   (b) illustrating a B-B sectional view of the semiconductor board.
FIG. 3 shows explanatory views for illustrating one embodiment of a method for producing a semiconductor device shown in FIG. 1:
   (a) illustrating a step of allowing a silicone resin sheet to be opposed to the upper side of the semiconductor board,
   (b) illustrating a step of attaching the silicone resin sheet to the upper surface of the semiconductor board,
   (c) illustrating a step of compressively bonding the silicone resin sheet, and
   (d) illustrating a step of curing an encapsulating resin layer in the silicone resin sheet.

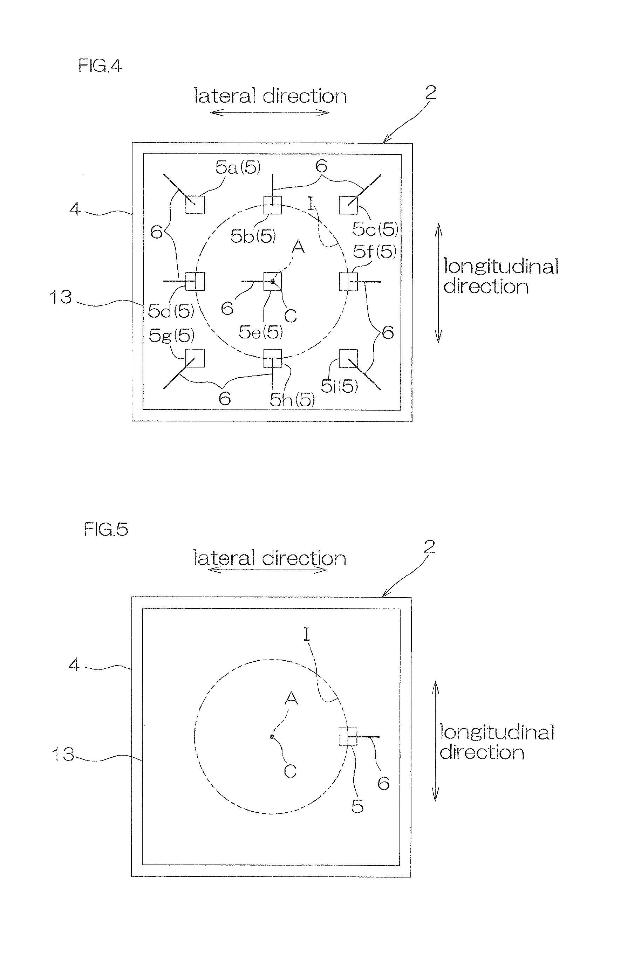

FIG. 4 shows an explanatory view for illustrating a positioning of the silicone resin sheet with respect to the semiconductor board.
FIG. 5 shows an explanatory view for illustrating Example 1.

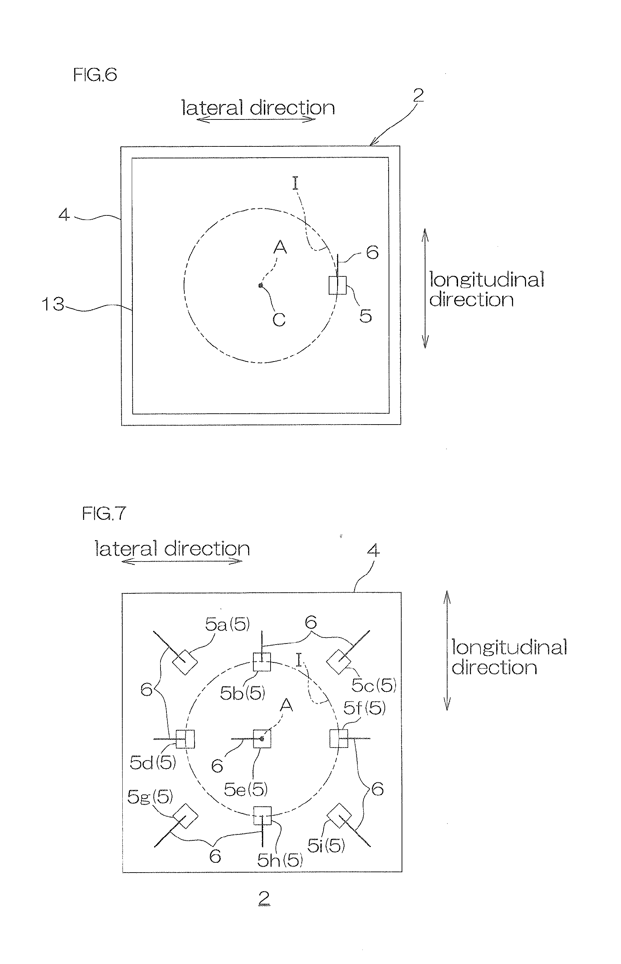

FIG. 6 shows an explanatory view for illustrating Comparative Example 1.
FIG. 7 shows an explanatory view for illustrating a modified example of the semiconductor board.

### DETAILED DESCRIPTION OF THE INVENTION

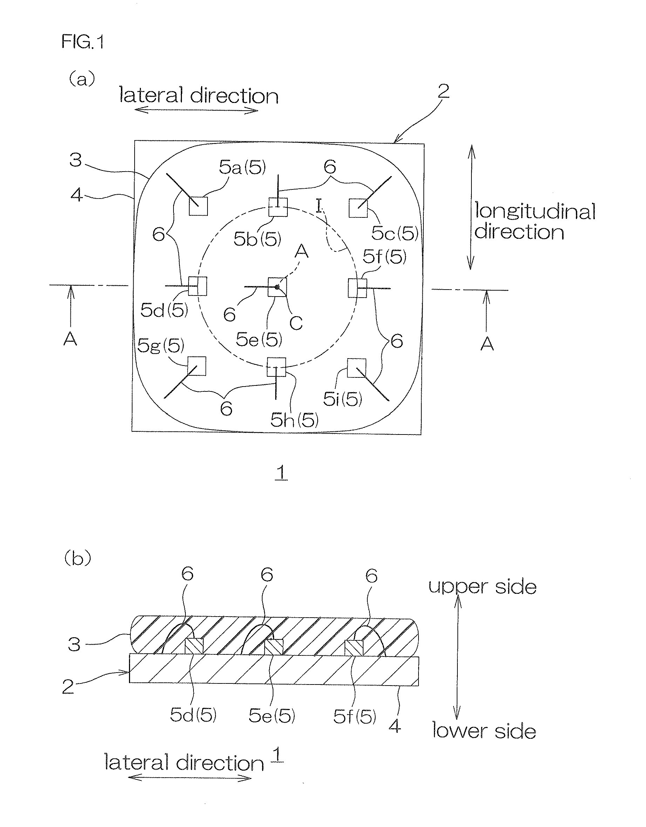

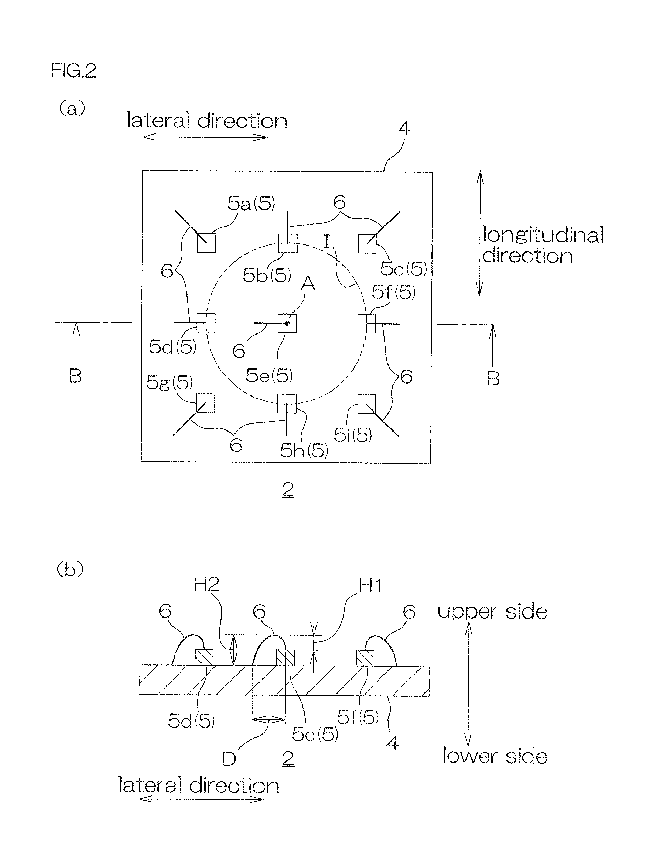

FIG. 1 shows one embodiment of a semiconductor device of the present invention. FIG. 2 shows a semiconductor board shown in FIG. 1.

As shown in FIG. 1, a semiconductor device 1 includes a semiconductor board 2 which is provided with light emitting diodes 5 (described later) and an encapsulating layer 3 which encapsulates the light emitting diodes 5 (described later).

In the following description, when referred to direction, a case where the semiconductor device 1 is horizontally put is defined as a reference. The up-down direction of the paper surface in FIG. 1 (a) is defined as a longitudinal direction and the right-left direction of the paper surface in FIG. 1 (a) is defined as a lateral direction. The longitudinal direction and the lateral direction are included in the horizontal direction. The up-down direction of the paper surface in FIG. 1 (b) is defined as an up-down direction.

As shown in FIG. 2, the semiconductor board 2 is formed into a flat plate shape in a generally rectangular shape in plane view. The semiconductor board 2 is provided with a circuit board 4, a plurality (nine pieces) of the light emitting diodes 5 ("a" to "i") as semiconductor elements, and a plurality (nine pieces) of wires 6.

The circuit board 4 is formed into a flat plate shape in a generally rectangular shape in plane view extending in the longitudinal direction and the lateral direction. The circuit board 4 is formed of a material which is generally used for an optical semiconductor device. Examples of the material include a metal material such as aluminum, a ceramic material such as alumina, and a resin material such as polyimide. The circuit board 4 is provided with a wiring pattern (not shown) on the upper surface thereof. The wiring pattern (not shown) is provided with a plurality of electrodes (not shown) so that each of a plurality of the electrodes corresponds to each of a plurality of the light emitting diodes 5. External electric power is supplied to the circuit board 4 (the wiring pattern (not shown) thereof).

A plurality of the light emitting diodes 5 are disposed on the upper surface (the upper surface of the circuit board 4 on which the wiring pattern (not shown) is not formed) of the circuit board 4 in such a way that a plurality (three pieces) thereof are disposed in parallel at spaced intervals to each other in the longitudinal direction and a plurality (three pieces) thereof are disposed in parallel at spaced intervals to each other in the lateral direction. Of a plurality of the light emitting diodes 5, a light emitting diode 5e which is disposed at the center in the longitudinal and lateral directions is disposed at the center (the center portion in the longitudinal and lateral directions) of the circuit board 4.

Each of the light emitting diodes 5 is formed into a flat plate shape in a generally rectangular shape in plane view and emits light based on electric power from the circuit board 4.

The length of one side of the light emitting diode 5 is, for example, 0.1 to 5 mm. The thickness of the light emitting diode 5 is, for example, 10 to 1000 µm.

The gap between the light emitting diodes 5 in the longitudinal and lateral directions is, for example, 0.1 to 50 mm, or preferably 1 to 5 mm.

Each of a plurality of the wires 6 is provided so as to correspond to each of a plurality of the light emitting diodes 5. The wires 6 are formed into linear shapes. One end of each of a plurality of the wires 6 is electrically connected to each of the upper surfaces of the light emitting diodes 5 and the other end thereof is electrically connected to the circuit board 4 (each of the electrodes (not shown) thereof).

An example of a material of the wires 6 includes a material used as a wire bonding material of a semiconductor such as gold, silver, and copper. In view of corrosion resistance, preferably, gold is used.

The wire diameter (thickness) of each of the wires 6 is, for example, 10 to 100 µm, or preferably 30 to 50 µm. When the wire diameter of each of the wires 6 exceeds the above-described range, there may be a case where the cost of the semiconductor board 2 is increased, a case where the area which interrupts light emission from the light emitting diodes 5 is increased, or a case where the contact area at the time of movement of an encapsulating resin is increased. When the wire diameter of each of the wires 6 is below the above-described range, there may be a case where the strength of the wires 6 is reduced and the wires 6 are easily deformed.

In a state where the light emitting diodes 5 are connected to the circuit board 4, the wires 6 are curved or bent to be formed into generally arch shapes (for example, triangular arch shapes, quadrilateral arch shapes, circular arch shapes, and the like).

A distance H1 in the up-down direction from one end of each of the wires 6 to the upper end portion thereof is, for example, 100 to 2000 µm, or preferably 300 to 1000 µm.

A distance H2 in the up-down direction from the other end of each of the wires 6 to the upper end portion thereof is, for example, 100 to 2000 µm, or preferably 300 to 1000 µm.

When the distance (H1, H2) in the up-down direction from one end or the other end of each of the wires 6 to the upper end portion thereof is within the above-described range, the deformation of the wires 6 can be suppressed.

A distance D in the horizontal direction between the both ends of each of the wires 6 is, for example, 0.2 to 5 mm, or preferably 0.5 to 2 mm. When the distance D in the horizontal direction between the both ends of each of the wires 6 exceeds the above-described range, the wires 6 may be easily deformed.

The wires 6 extend over from one end to the other end so as to be along the radial direction of a phantom circle I having a reference point A as a center on the circuit board 4.

The reference point A is a point which serves as a reference for positioning the center of a silicone resin sheet 11 to be described later and is arbitrarily set on the circuit board 4. In the embodiment, the reference point A is set to be the center (the center portion in the longitudinal and lateral directions) of the circuit board 4.

That is, a plurality of the light emitting diodes 5 described above are disposed in a plurality of rows (four rows) so as to be along the radial direction of the phantom circle I (described later).

To be specific, in the embodiment, a plurality of the light emitting diodes 5 are disposed in a total of four rows: a row (one row) consisting of three pieces of the light emitting diodes 5 ("b", "e", "h") disposed in parallel in the longitudinal direction at the center in the lateral direction of the circuit board 4, a row (one row) consisting of three pieces of the light emitting diodes 5 ("d", "e", "f") disposed in parallel in the lateral direction at the center in the longitudinal direction of the circuit board 4, and the rows (two rows) consisting of three pieces of the light emitting diodes 5 (("a", "e", "i") or ("c", "e", "g")) disposed in parallel along each of the two diagonal lines of the circuit board 4.

As shown in FIG. 1, the encapsulating layer 3 is laminated on the upper surface of the circuit board 4 so as to cover the light emitting diodes 5. The encapsulating layer 3 is, though described in details later, prepared from a silicone resin.

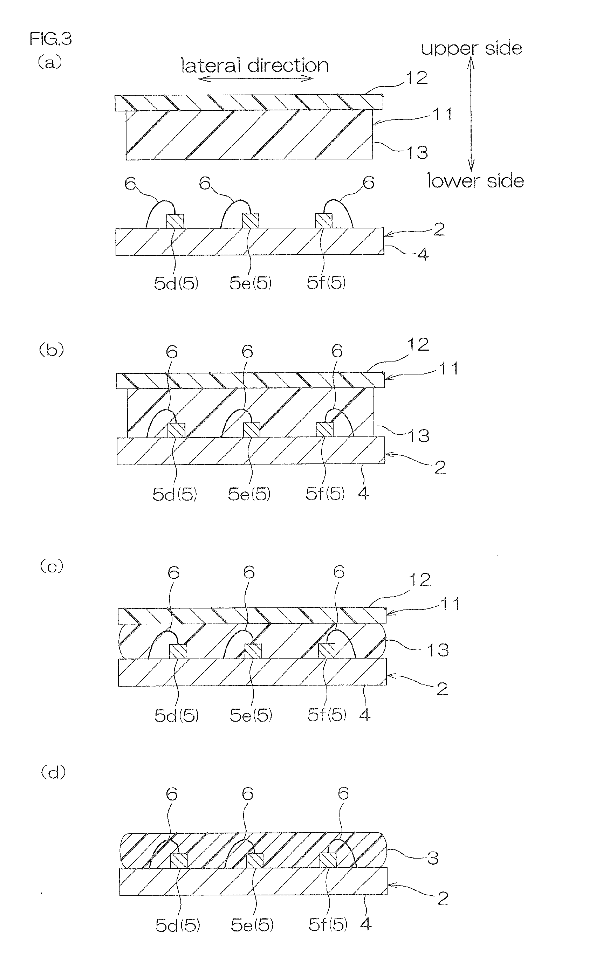

FIGS. 3 and 4 show explanatory views for illustrating a method for producing a semiconductor device of the present invention.

Next, a method for producing the semiconductor device 1 is described.

In order to produce the semiconductor device 1, first, the above-described semiconductor board 2 is prepared.

Also, in order to produce the semiconductor device 1, the silicone resin sheet 11 as an encapsulating sheet is separately prepared.

As shown in FIGS. 3 (a) and 4, the silicone resin sheet 11 is formed into a sheet shape in a generally rectangular shape in plane view and includes a release film 12 and an encapsulating resin layer 13 laminated on the release film 12. The shape of the silicone resin sheet 11 is not limited to the above-described generally rectangular shape in plane view and is appropriately set in accordance with the shape of the semiconductor board 2 or the arrangement of the light emitting diodes 5. Examples of the shape of the silicone resin sheet 11 include a generally circular shape in plane view and a generally polygonal shape in plane view.

The release film 12 is formed of a resin film. Examples of the resin film include a polyethylene terephthalate film, a polystyrene film, a polypropylene film, a polycarbonate film, an acrylic film, a silicone resin film, a styrene resin film, and a fluorine resin film. The surface of the release film 12 may be subjected to a release treatment.

The thickness of the release film 12 is, for example, 20 to 100 µm, or preferably 30 to 50 µm. When the thickness of the release film 12 is within the above-described range, an excellent handling ability (the handling ability at the time of peeling the release film 12 from the silicone resin sheet 11) can be achieved, while an increase in the cost is suppressed.

The encapsulating resin layer 13 is formed from an encapsulating resin composition which contains a silicone resin as an encapsulating resin.

An example of the encapsulating resin composition includes a thermosetting silicone resin composition such as a two-step curable type silicone resin composition and a one-step curable type silicone resin composition.

The two-step curable type silicone resin composition is defined as a thermosetting silicone resin composition which has a two-step reaction mechanism and in which the resin is brought into a B-stage state (a semi-cured state) in the first-step reaction and is brought into a C-stage state (a final-cured state) in the second-step reaction.

The B-stage state is a state between an A-stage state in which an encapsulating resin composition is soluble in a solvent and a C-stage state in which an encapsulating resin composition is subjected to a final curing. Also, the B-stage state is a state in which the curing and the gelation of the encapsulating resin composition are slightly progressed to be swollen but not to be completely dissolved in a solvent and also to be softened but not to be melted by heating.

An example of an uncured material (before curing in the first step) of the two-step curable type silicone resin composition includes a condensation reaction and addition reaction curable type silicone resin composition.

The condensation reaction and addition reaction curable type silicone resin composition is a thermosetting silicone resin composition which can undergo a condensation reaction and an addition reaction by heating. To be more specific, the condensation reaction and addition reaction curable type silicone resin composition is a thermosetting silicone resin composition which can be brought into a B-stage state (a semi-cured state) by undergoing the condensation reaction by heating and then, be brought into a C-stage state (a final-cured state) by undergoing the addition reaction (to be specific, for example, a hydrosilylation reaction) by further heating.

Examples of the condensation reaction and addition reaction curable type silicone resin composition include a first condensation reaction and addition reaction curable type silicone resin composition which contains a polysiloxane containing silanol groups at both ends, an alkenyl group-containing trialkoxysilane, an organohydrogensiloxane, a condensation catalyst, and a hydrosilylation catalyst; a second condensation reaction and addition reaction curable type silicone resin composition which contains a polysiloxane containing silanol groups at both ends, a silicon compound containing an ethylenically unsaturated hydrocarbon group (hereinafter, defined as an ethylenic silicon compound), an epoxy group-containing silicon compound, an organohydrogensiloxane, a condensation catalyst, and an addition catalyst (a hydrosilylation catalyst); a third condensation reaction and addition reaction curable type silicone resin composition which contains a silicone oil containing silanol groups at both ends, an alkenyl group-containing dialkoxyalkylsilane, an organohydrogensiloxane, a condensation catalyst, and a hydrosilylation catalyst; a fourth condensation reaction and addition reaction curable type silicone resin composition which contains an organopolysiloxane having, in one molecule, at least two alkenylsilyl groups, an organopolysiloxane having, in one molecule, at least two hydrosilyl groups, a hydrosilylation catalyst, and a curing retarder; a fifth condensation reaction and addition reaction curable type silicone resin composition which contains a first organopolysiloxane having, in one molecule, both at least two ethylenically unsaturated hydrocarbon groups and at least two hydrosilyl groups, a second organopolysiloxane having, in one molecule, at least two hydrosilyl groups without containing an ethylenically unsaturated hydrocarbon group, a hydrosilylation catalyst, and a hydrosilylation retarder; a sixth condensation reaction and addition reaction curable type silicone resin composition which contains a first organopolysiloxane having, in one molecule, both at least two ethylenically unsaturated hydrocarbon groups and at least two silanol groups, a second organopolysiloxane having, in one molecule, at least two hydrosilyl groups without containing an ethylenically unsaturated hydrocarbon group, a hydrosilylation retarder, and a hydrosilylation catalyst; a seventh condensation reaction and addition reaction curable type silicone resin composition which contains a silicon compound, and a boron compound or an aluminum compound; and an eighth condensation reaction and addition reaction curable type silicone resin composition which contains polyaluminosiloxane and a silane coupling agent.

These condensation reaction and addition reaction curable type silicone resin compositions can be used alone or in combination of two or more.

As the condensation reaction and addition reaction curable type silicone resin composition, preferably, a second condensation reaction and addition reaction curable type silicone resin composition is used.

In the second condensation reaction and addition reaction curable type silicone resin composition, the polysiloxane containing silanol groups at both ends, the ethylenic silicon compound, and the epoxy group-containing silicon compound are condensation materials (materials subjected to a condensation reaction) and the ethylenic silicon compound and the organohydrogensiloxane are addition materials (materials subjected to an addition reaction).

On the other hand, the one-step curable type silicone resin composition is defined as a thermosetting silicone resin composition which has a one-step reaction mechanism and in which the resin is subjected to a final curing in the first-step reaction.

An example of the one-step curable type silicone resin composition includes an addition reaction curable type silicone resin composition.

The addition reaction curable type silicone resin composition contains a polysiloxane containing an ethylenically unsaturated hydrocarbon group which serves as a main agent and an organohydrogensiloxane which serves as a cross-linking agent.

Examples of the polysiloxane containing an ethylenically unsaturated hydrocarbon group include an alkenyl group-containing polydimethylsiloxane, an alkenyl group-containing polymethylphenylsiloxane, and an alkenyl group-containing polydiphenylsiloxane.

In the addition reaction curable type silicone resin composition, the polysiloxane containing an ethylenically unsaturated hydrocarbon group and the organohydrogensiloxane are usually provided in separate packages. To be specific, the addition reaction curable type silicone resin composition is provided as two liquids of A liquid which contains a main agent (the polysiloxane containing an ethylenically unsaturated hydrocarbon group) and B liquid which contains a cross-linking agent (the organohydrogensiloxane). A known catalyst which is necessary for the addition reaction of both components is added in the polysiloxane containing an ethylenically unsaturated hydrocarbon group.

In the addition reaction curable type silicone resin composition, the main agent (A liquid) and the cross-linking agent (B liquid) are mixed to prepare a liquid mixture. In a step of forming the prepared liquid mixture into the above-described shape of the encapsulating resin layer 13, the polysiloxane containing an ethylenically unsaturated hydrocarbon group and the organohydrogensiloxane undergo the addition reaction and the addition reaction curable type silicone resin composition is cured, so that a silicone elastomer (a cured material) is formed.

The encapsulating resin layer 13 is, for example, prepared from a thermosetting silicone resin composition before final curing or after final curing. Preferably, the encapsulating resin layer 13 is prepared from a thermosetting silicone resin composition before final curing.

More preferably, when the thermosetting silicone resin composition is a two-step curable type silicone resin composition, the encapsulating resin layer 13 is prepared from a first-step cured material of the two-step curable type silicone resin composition and when the thermosetting silicone resin composition is a one-step curable type silicone resin composition, the encapsulating resin layer 13 is prepared from an uncured material (before curing) of the one-step curable type silicone resin composition.

Particularly preferably, the encapsulating resin layer 13 is a first-step cured material of the two-step curable type silicone resin composition.

A phosphor and a filler can be contained in the encapsulating resin layer 13 at an appropriate proportion as required.

An example of the phosphor includes a yellow phosphor which is capable of converting blue light into yellow light. An example of the phosphor includes a phosphor obtained by doping a metal atom such as cerium (Ce) or europium (Eu) into a composite metal oxide, a metal sulfide, or the like.

To be specific, examples of the phosphor include a garnet type phosphor having a garnet type crystal structure such as Y₃Al₅O₁₂:Ce (YAG (yttrium aluminum garnet):Ce), (Y, Gd)₃Al₅O₁₂:Ce, Tb₃Al₃O₁₂:Ce, Ca₃Sc₂Si₃O₁₂:Ce, and Lu₂CaMg₂(Si, Ge)₃O₁₂:Ce; a silicate phosphor such as (Sr, Ba)₂SiO₄:Eu, Ca₃SiO₄Cl₂:Eu, Sr₃SiO₅:Eu, Li₂SrSiO₄:Eu, and Ca₃Si₂O₇:Eu; an aluminate phosphor such as CaAl₁₂O₁₉:Mn and SrAl₂O₄:Eu; a sulfide phosphor such as ZnS:Cu,Al, CaS:Eu, CaGa₂S₄:Eu, and SrGa₂S₄:Eu; an oxynitride phosphor such as CaSi₂O₂N₂:Eu, SrSi₂O₂N₂:Eu, BaSi₂O₂N₂:Eu, and Ca-α-SiAlON; a nitride phosphor such as CaAlSiN₃:Eu and CaSi₅N₈:Eu; and a fluoride-based phosphor such as K₂SiF₆:Mn and K₂TiF₆:Mn. Preferably, a garnet type phosphor is used, or more preferably, Y₃Al₅O₁₂:Ce is used.

Examples of the filler include silicone microparticles, glass, alumina, silica (fused silica, crystalline silica, ultrafine amorphous silica, hydrophobic ultrafine silica, and the like), titania, zirconia, talc, clay, and barium sulfate. These fillers can be used alone or in combination of two or more. Preferably, silicone microparticles and silica are used.

A known additive can be added to the encapsulating resin layer 13 at an appropriate proportion. Examples of the known additive include modifiers, surfactants, dyes, pigments, discoloration inhibitors, and ultraviolet absorbers.

The hardness of the encapsulating resin layer 13 is a hardness such that the compressive elastic modulus thereof is, for example, 0.01 MPa or more, preferably 0.01 to 1.0 MPa, or more preferably 0.04 to 0.2 MPa.

The encapsulating resin layer 13 is formed to have a size capable of collectively encapsulating a plurality of the light emitting diodes 5 and a plurality of the wires 6.

To be specific, in the embodiment, the length in the longitudinal direction of the silicone resin sheet 11 is, for example, not less than a distance between the one end (the end portion electrically connected to the electrodes (not shown) in the circuit board 4, hereinafter the same) of the wire 6 of the light emitting diode 5 which is disposed at the most outer side at one side in the longitudinal direction and the other end of the wire 6 of the light emitting diode 5 which is disposed at the most outer side at the other side in the longitudinal direction. The length in the longitudinal direction of the silicone resin sheet 11 is, for example, not more than the length in the longitudinal direction of the circuit board 4.

Also, the length in the lateral direction of the silicone resin sheet 11 is, for example, not less than a distance between the one end of the wire 6 of the light emitting diode 5 which is disposed at the most outer side at one side in the lateral direction and the other end of the wire 6 of the light emitting diode 5 which is disposed at the most outer side at the other side in the lateral direction. The length in the lateral direction of the silicone resin sheet 11 is, for example, not more than the length in the lateral direction of the circuit board 4.

The thickness of the silicone resin sheet 11 is not particularly limited and is, for example, 100 to 2000 µm, or preferably 300 to 1000 µm.

In order to produce the semiconductor device 1, as shown in FIG. 3 (a), the silicone resin sheet 11 is disposed at the upper side of the semiconductor board 2 so that the encapsulating resin layer 13 is spaced in opposed relation to the light emitting diodes 5 in the up-down direction.

At this time, as shown in FIG. 4, the silicone resin sheet 11 is positioned in such a way that a center C (the center portion in the longitudinal and lateral directions) thereof is, when projected in the up-down direction, generally matched with the reference point A on the circuit board 4.

Next, as shown in FIG. 3 (b), the silicone resin sheet 11 is lowered (pressed downwardly) and the light emitting diodes 5 and the wires 6 are covered with the encapsulating resin layer 13.

Next, as shown in FIG. 3 (c), the silicone resin sheet 11 is compressively bonded with respect to the semiconductor board 2. Preferably, the compressive bonding is performed under a reduced pressure atmosphere.

The compressive bonding is performed by controlling the amount (hereinafter, defined as a pushed-in amount) in which the encapsulating resin layer 13 is pushed into (compressed into) the semiconductor board 2 side (the lower side).

The pushed-in amount is represented by the following formula.

Pushed-in amount = Thickness L1 of the encapsulating resin layer 13 before the compression (the compressive bonding) - Thickness L2 of the encapsulating resin layer 13 after the compression (the compressive bonding)

The pushed-in amount is adjusted so that a pushed-in rate represented by the following formula is set to be, for example, 5 to 30 %.

The pushed-in rate = Pushed-in amount / Thickness L1 of the encapsulating resin layer 13 before the compression (the compressive bonding) × 100 %

To be specific, the silicone resin sheet 11 is compressively bonded so that the thickness of the encapsulating resin layer 13 is compressed by the pushed-in amount.

By adjusting the pushed-in amount in this way, a collapse of the silicone resin sheet 11 is prevented, so that the light emitting diodes 5 can be surely encapsulated by the silicone resin sheet 11.

The temperature of the compressive bonding is, for example, 0 to 40°C, or preferably 15 to 35°C.

In the compressive bonding, the silicone resin sheet 11 is retained in a state where it is pressed downwardly (pushed in) as required.

The retention duration in the compressive bonding is, for example, 10 seconds to 10 minutes, or preferably 10 seconds to 5 minutes.

In the compressive bonding, though not shown, a known pressing machine is used.

When the silicone resin sheet 11 is compressively bonded with respect to the semiconductor board 2 as described above, the silicone resin sheet 11 is compressed in the up-down direction so as to expand from the center C thereof in the horizontal direction (that is, the longitudinal and lateral directions). That is, the silicone resin sheet 11 is deformed so as to extend from the reference point A on the circuit board 4 toward the outer side in the radial direction of the phantom circle I.

Also, as described above, the wires 6 in the semiconductor board 2 extend along the radial direction of the phantom circle I so that the direction in which the wires 6 extend is matched with the direction in which the silicone resin sheet 11 extends.

In this way, when the silicone resin sheet 11 is compressed and deformed, the pressing force of the encapsulating resin which is deformed by movement with respect to the wires 6 is reduced.

In order to produce the semiconductor device 1, as shown in FIG. 3 (d), if necessary (for example, when the encapsulating resin layer 13 in the silicone resin sheet 11 contains a thermosetting resin), the encapsulating resin layer 13 is cured by heating to be formed as the encapsulating layer 3.

The curing conditions are the conditions in which the thermosetting resin in the encapsulating resin layer 13 described above is completely cured and are the conditions in which, when the encapsulating resin layer 13 contains a condensation reaction and addition reaction curable type silicone resin composition, an addition reaction (a hydrosilylation reaction) is progressed.

To be specific, the heating temperature is, for example, 80 to 200°C, or preferably 100 to 180°C and the heating duration is, for example, 0.1 to 20 hours, or preferably 1 to 10 hours.

Thereafter, as shown in FIG. 3 (d), when the release film 12 is peeled from the encapsulating layer 3, the fabrication of the semiconductor device 1 is completed.

According to the method for producing the semiconductor device 1, the semiconductor board 2 in which the wires 6 are disposed so as to be along the radial direction of the phantom circle I having the reference point A as a center on the circuit board 4 is encapsulated by the silicone resin sheet 11.

Therefore, when the silicone resin sheet 11 is compressively bonded to the semiconductor board 2, the silicone resin sheet 11 is compressed so as to extend from the reference point A on the circuit board 4 toward the outer side in the radial direction of the phantom circle I, so that the direction in which the silicone resin sheet 1 extends and the direction in which the wires 6 extend can be substantially matched with each other.

In this way, the pressing force with respect to the wires 6 at the time of compression of the silicone resin sheet 11 can be reduced.

As a result, the deformation of the wires 6 at the time of encapsulating the light emitting diodes 5 can be suppressed.

In the above-described embodiment, one piece of the wire 6 is provided corresponding to each of a plurality of the light emitting diodes 5. Alternatively, for example, two pieces of the wires 6 can be provided corresponding to each of a plurality of the light emitting diodes 5.

In such a case, two pieces of the wires 6 are provided in one piece of the light emitting diode 5 so that two pieces of the wires 6 are along the radial direction of the phantom circle I and extend in an opposite direction to each other.

In the above-described embodiment, a plurality (nine pieces) of the light emitting diodes 5 and a plurality (nine pieces) of the wires 6 are provided. Alternatively, one piece of the light emitting diode 5 and one piece of the wire 6 may be provided.

In such a case, the silicone resin sheet 11 is pressurized with respect to the semiconductor board 2 so as to be deformed toward the direction in which the wire 6 extends.

In this way, the direction in which the silicone resin sheet 11 extends and the direction in which the wire 6 extends can be substantially matched with each other.

As a result, the pressing force with respect to the wire 6 at the time of compression of the silicone resin sheet 11 can be reduced in the same manner as the above-described embodiment.

In the above-described embodiment, all of the light emitting diodes 5 are disposed so that the sides thereof are along the longitudinal direction or the lateral direction. However, as long as the wires 6 extend along the radial direction of the phantom circle I, the direction of the light emitting diodes 5 is not particularly limited.

As shown in FIG. 7, for example, the light emitting diodes 5 can be also disposed in such a way that the two sides of the four sides thereof which are opposed to each other are along the direction in which the wires 6 extend. In such a case, the remaining two sides thereof are perpendicular to the direction in which the wires 6 extend.

### Examples

While the present invention will be described hereinafter in further detail with reference to Examples and Comparative Examples, the present invention is not limited to these Examples and Comparative Examples.

### 1. Examples and Comparative Examples

### Example 1

At a position which was separated by 5 mm from a reference point A (a center of a circuit board) on a circuit board 4 (in a square shape in plane view having a side of 30 mm in length), a light emitting diode 5 (in a square shape in plane view having a side of 1 mm in length and a thickness of 100 µm) was connected onto the upper surface of the circuit board 4 by a wire bonding method, so that a semiconductor board 2 was prepared.

To be specific, using a wire 6 which was made of gold and had a wire diameter of 30 µm, an element-side end portion thereof was connected to the light emitting diode 5 and a board-side end portion thereof was connected to the circuit board 4 so that the direction which connected one end portion (the element-side end portion) to the other end portion (the board-side end portion) was along the radial direction of a phantom circle I having the reference point A as a center on the circuit board 4 (ref: FIG. 5). The wire 6 was curved into a generally U-shape with its lower side open.

A distance in the up-down direction from the element-side end portion to the most upper end portion of the wire was 300 µm. A distance in the up-down direction from the board-side contact point to the most upper portion of the wire was 450 µm. A distance in the horizontal direction between the element-side contact point and the board-side contact point was 1.5 mm.

Also, a silicone resin sheet (in a square shape in plane view having a side of 15 mm in length and a thickness of 600 µm) was separately prepared.

Next, a silicone resin sheet 11 was positioned in such a way that a center C thereof was, when projected in the up-down direction, generally matched with the reference point A on the circuit board 4 (ref: FIGS. 3 (a) and 5).

Next, the silicone resin sheet 11 was lowered and the light emitting diodes 5 and the wires 6 were covered with an encapsulating resin layer 13 (ref: FIG. 3 (b)).

Next, the silicone resin sheet 11 was pressurized with respect to the semiconductor board 2 (ref: FIG. 3 (c)).

The pressurizing conditions were as follows: a pushed-in amount of 100 µm (a pushed-in rate of 16.7 % = a pushed-in amount of 100 µm / a thickness of an encapsulating resin layer before the compression (the compressive bonding) of 600 µm × 100 %), a pressurizing temperature of 25°C, and a pressurizing duration of 40 seconds.

The thickness of the encapsulating resin layer after the compressive bonding was 500 µm (83.3 % with respect to that before the compression).

The deformation of the wires was not confirmed and the encapsulation was possible.

### Example 2

Nine pieces of the light emitting diodes 5 were disposed on the circuit board 4 in such a way that three pieces thereof were disposed in parallel at spaced intervals of 5 mm to each other in the longitudinal direction and three pieces thereof were disposed in parallel at spaced intervals of 5 mm to each other in the lateral direction. The light emitting diode 5 which was disposed at the center in the longitudinal and lateral directions was disposed on the reference point A on the circuit board 4 (ref: FIG. 2 (a)).

A semiconductor device was fabricated in the same manner as in Example 1, except that all of the wires 6 were provided so as to be along the radial direction of the phantom circle I having the reference point A as a center (ref: FIG. 2 (a)).

The deformation of the wires was not confirmed and the encapsulation was possible.

### Comparative Example 1

A semiconductor device was fabricated in the same manner as in Example 1, except that the element-side end portion of the wire 6 was connected to the light emitting diode 5 and the board-side end portion thereof was connected to the circuit board 4 so that the direction which connected one end portion (the element-side end portion) to the other end portion (the board-side end portion) was along the direction tangent to the phantom circle I having the reference point A as a center on the circuit board 4 (ref: FIG. 6).

The deformation of the wire was confirmed at the time of compressive bonding.

### Comparative Example 2

A semiconductor device was fabricated in the same manner as in Example 2, except that all of the wires 6 were provided so as to be along the lateral direction.

The deformation of the wires was confirmed at the time of compressive bonding.

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

## Claims

1. A semiconductor board comprising:
a circuit board to which external electric power is supplied;
a plurality of semiconductor elements which are supported on the circuit board, and
a plurality of wires each of which is provided corresponding to each of a plurality of the semiconductor elements and each of which has one end electrically connected to the semiconductor element and the other end electrically connected to the circuit board, wherein
a plurality of the wires extend along a radial direction of a phantom circle having a center on the circuit board.

2. The semiconductor board according to claim 1, wherein
a plurality of the semiconductor elements are disposed in a plurality of rows so as to be along the radial direction of the phantom circle.

3. The semiconductor board according to claim 1, wherein
a plurality of the semiconductor elements are light emitting diodes.

4. The semiconductor board according to claim 1, wherein
the wire diameter of each of a plurality of the wires is 10 to 100 µm.

5. A semiconductor device comprising:
a semiconductor board according to any one of the preceding claims 1 to 4, and
an encapsulating layer.

6. The semiconductor board according to claim 5, wherein
the encapsulating layer is obtained by allowing an encapsulating sheet formed from an encapsulating resin into a sheet shape to be cured.

7. The semiconductor device according to claim 6, wherein
the encapsulating resin is a silicone resin.

8. A method for producing a semiconductor device comprising the steps of:
preparing a semiconductor board which includes a circuit board to which external electric power is supplied, a semiconductor element which is supported on the circuit board, and a wire which has one end electrically connected to the semiconductor element and the other end electrically connected to the circuit board;
disposing an encapsulating sheet formed from an encapsulating resin into a sheet shape at the upper side of the semiconductor board; and
pressurizing the encapsulating sheet with respect to the semiconductor board so a to be deformed toward the direction in which the wire extends.

9. A method for producing a semiconductor device according to claim 8, comprising the steps of:
preparing a semiconductor board, the semiconductor board comprising
a circuit board to which external electric power is supplied,
a plurality of semiconductor elements which are supported on the circuit board, and
a plurality of wires each of which is provided corresponding to each of a plurality of the semiconductor elements and each of which has one end electrically connected to the semiconductor element and the other end electrically connected to the circuit board,
a plurality of the wires extending along a radial direction of the phantom circle having a center on the circuit board;
disposing an encapsulating sheet formed from an encapsulating resin into a sheet shape at the upper side of the semiconductor board; and
pressurizing the encapsulating sheet with respect to the semiconductor board so as to be deformed toward the direction in which a plurality of the wires extend.
